# EUROPÄISCHE PATENTSCHRIFT

(11) **EP 3 233 718 B1**
(45) Veröffentlichungstag und Bekanntmachung des Hinweises auf die Patenterteilung: **15.07.2020**
(21) Anmeldenummer: 15817137.1
(22) Anmeldetag: 14.12.2015
(51) Int. Cl.: B81C 1/00, B82B 3/00, H05K 3/12, H05K 3/10

(54) **VERFAHREN ZUR HERSTELLUNG EINES MIT NANODRÄHTEN STRUKTURIERTEN SUBSTRATS, HERGESTELLTES SUBSTRAT UND VERWENDUNG DES SUBSTRATS**
METHOD FOR PRODUCING A SUBSTRATE STRUCTURED BY NANOWIRES, PRODUCED SUBSTRATE, AND USE OF THE SUBSTRATE
PROCÉDÉ DE PRODUCTION D'UN SUBSTRAT STRUCTURÉ AVEC DES NANOFILS, SUBSTRAT PRODUIT ET UTILISATION DU SUBSTRAT

(30) Priorität: 19.12.2014 DE 102014226649
(43) Veröffentlichungstag der Anmeldung: 25.10.2017
(73) Patentinhaber: Universität Ulm, 89081 Ulm (DE)
(72) Erfinder: STREHLE, Steffen, 89075 Ulm (DE); ROSSKOPF, Daniel Markus, 89075 Ulm (DE); PROBST, Andreas Magnus, 87784 Westerheim (DE)
(74) Vertreter: Pfenning, Meinig & Partner mbB
(86) Internationale Anmeldenummer: PCT/EP2015/079605
(87) Internationale Veröffentlichungsnummer: WO 2016/096735

(56) Entgegenhaltungen:
- JUN YAO ET AL: "A nanoscale combing technique for the large-scale assembly of highly aligned nanowires", NATURE NANOTECHNOLOGY, Bd. 8, Nr. 5, 21. April 2013 (2013-04-21), Seiten 329-335, XP055253608, GB ISSN: 1748-3387, DOI: 10.1038/nnano.2013.55
- TOSHITAKE TAKAHASHI ET AL: "Monolayer Resist for Patterned Contact Printing of Aligned Nanowire Arrays", JOURNAL OF THE AMERICAN CHEMICAL SOCIETY, Bd. 131, Nr. 6, 18. Februar 2009 (2009-02-18), Seiten 2102-2103, XP055253250, US ISSN: 0002-7863, DOI: 10.1021/ja8099954
- ALI JAVEY ET AL: "Layer-by-Layer Assembly of Nanowires for Three-Dimensional, Multifunctional Electronics", NANO LETTERS, Bd. 7, Nr. 3, 1. März 2007 (2007-03-01), Seiten 773-777, XP055253612, US ISSN: 1530-6984, DOI: 10.1021/nl063056l
- Huaping Liu ET AL: "Transfer and Alignment of Random Single-Walled Carbon Nanotube Films by Contact Printing", ACS Nano, vol. 4, no. 2, 23 February 2010 (2010-02-23), pages 933-938, XP055531328, US ISSN: 1936-0851, DOI: 10.1021/nn901741y

## Beschreibung

Die Erfindung betrifft ein Verfahren zur Herstellung eines mit Nanodrähten strukturierten Substrats, ein mit Nanodrähten strukturiertes Substrat und Verwendungen eines solchen Substrats.

Die Synthese von Nanodrähten (z.B. "bottom-up") eröffnet vollkommen neue Perspektiven zur direkten Herstellung komplexer Nanostrukturen. Das Wachstum der individuellen Nanodrähte auf Substraten erfolgt allerdings zumeist dreidimensional und lokal statistisch verteilt. Substrate der Mikroelektronik, Mikrosystemtechnik und Sensorik könnten von den Nanodrähten profitieren, weisen im Allgemeinen aber planare Geometrien mit definierter Anordnung funktioneller Strukturen auf. Die Schwierigkeit besteht somit darin, die zumeist statistisch und dreidimensional auf dem Donorsubstrat verteilten Nanodrähte in einer definierten Geometrie auf Substrate der Mikroelektronik und Sensorik planar abzulegen. Mit anderen Worten wird eine Technologie benötigt, die es ermöglicht, Nanodrähte gezielt und planar auf eine funktionelle Unterlage (zukünftiges Bauelement, z.B. der Mikroelektronik) zu übertragen. Ein gezielter Transfer meint hierbei eine Kontrolle über die Ausrichtung, die Abscheidungsdichte und die Positionierung der Nanodrähte entlang der Oberfläche des Substrats (primär in den zwei lateralen Richtungen d.h. die Länge und Breite des Substrats).

Das einfachste Verfahren Nanodrähte auf ein Zielsubstrat zu transferieren ist, diese vom ursprünglichen Donorsubstrat zu brechen und direkt, oder gelöst z.B. in Ethanol, zu übertragen. Dieses Verfahren erlaubt nahezu keine Kontrolle über die laterale Position oder die Ausrichtung der Nanodrähte d.h. die Nanodrähte werden statistisch verteilt auf dem Zielsubstrat abgeschieden. Die funktionelle Integration (z.B. elektrische Kontakte) muss folglich nachträglich für jeden Nanodraht individuell erfolgen, was im Widerspruch zu einer parallelen Fertigung und einem effizienten Verfahren steht.

Im Stand der Technik wurden Verfahren entwickelt, wie z.B. die Manipulation bzw. Ausrichtung von Nanodrähten mit elektrischen Feldern, akustischen Oberflächenwellen (SAW) oder definierte Flüssigkeitsströmungen (z.B. Langmuir-Blodgett), um die Nanodrähte auf dem Zielsubstrat nach deren Abscheidung zu orientieren. Obwohl lokal durchaus gute Ergebnisse erzielt wurden, ist mit keiner der bekannten Techniken eine Skalierbarkeit, Kompatibilität mit moderner Mikrofabrikation, Flexibilität, Reproduzierbarkeit und laterale Kontrolle bzgl. Ausrichtung und Position der Nanodrähte möglich. Insbesondere bei der Verwendung von SAW oder elektrischen Feldern ist der experimentelle Aufwand sehr hoch und komplex. Die Kompatibilität mit der Mikroelektronik ist hierbei auch z.T. stark beschränkt. Zudem ist den bekannten Verfahren gemein, dass die Nanodrahtabscheidung aus einer Flüssigkeit erfolgt, was den Nachteil von Schädigungen oder Kontaminationseffekten mit sich bringt.

Im Stand der Technik ist das sog. "Contact Printing" bekannt. Hierbei steht das Donorsubstrat mit den Nanodrähten im mechanischen Kontakt mit dem funktionellen Substrat. Durch relative Bewegung der beiden Unterlagen zueinander werden die Nanodrähte abgelöst und in Richtung der Bewegung ausgerichtet. So beschreibt Huaping Liu ET AL: "Transfer and Alignment of Random Single-Walled Carbon Nanotube Films by Contact Printing", ACS Nano, Bd. 4, Nr. 2, 23. Februar 2010 (2010-02-23), Seiten 933-938 ein Verfahren zur Herstellung eines mit Nanodrähten strukturierten Substrats, umfassend die Schritte: a) Bereitstellung eines Substrates, das an einer Oberfläche mindestens einen ersten Bereich und mindestens einen zweiten Bereich, einen Graben, enthält, und der erste Bereich den zweiten Bereich zumindest bereichsweise kontaktiert, b) Anpressen eines Donorsubstrats enthaltend Nanodrähte mit einem bestimmten Anpressdruck auf den ersten Bereich des Substrats, sodass die Nanodrähte zumindest bereichsweise den ersten Bereich des Substrats kontaktieren, und c) Bewegen des Donorsubstrats relativ zu dem Substrat in Richtung von dem ersten Bereich über mindestens den zweiten Bereich mit einer bestimmten Geschwindigkeit; wobei in dem Verfahren kein Gleitmittel verwendet wird und durch das Bewegen des Donorsubstrats in Schritt c) und die unterschiedlichen Eigenschaften der beiden Bereiche selektiv an lokal definierten Stellen des ersten und/oder zweiten Bereichs eine bestimmte Anzahl Nanodrähte abgelegt wird. Entsprechend offenbart dieses Dokument auch ein so erhaltenes Substrat. Eine Kontrolle der lokalen Nanodrahtdeposition wird typischerweise bisher jedoch nur in Kombination mit einem Photolackprozess erreicht d.h. es wird vor dem Druck Fotolack auf der funktionellen Unterlage (d.h. dem Zielsubstrat) aufgebracht und anschließend mikrotechnologisch strukturiert. Im nachfolgenden Kontaktdruck werden Nanodrähte sowohl auf den Fotolackbedeckten als auch auf den Fotolack-freien Bereichen des Zielsubstrats deponiert. Wird der Fotolack anschließend entfernt, so werden mit ihm die Nanodrähte entfernt, die auf dem Fotolack deponiert wurden. Es verbleiben somit einzig die Nanodrähte auf dem Zielsubstrat, welche in den Fotolack-freien Bereichen des Zielsubstrats deponiert wurden ("lift-off-Prozess"). Es ist in diesem Verfahren bekannt, dass die Abscheidungsdichte der Nanodrähte auf dem Zielsubstrat von dem Anpressdruck, der chemischen Funktionalisierung der Oberfläche und von der Gegenwart eines Gleichmittels (z.B. Silikonöl) beeinflusst wird. Insbesondere kann eine chemische Oberflächenfunktionalisierung zwar zu einer höheren Abscheidungsdichte der Nanodrähte führen, hat aber den Nachteil, dass sie nicht langzeitstabil ist (besonders unter Gleitmitteleinwirkung) und Gleitmittel, aber auch Oberflächenfunktionalisierungen, für die moderne Mikrofabrikation nur sehr eingeschränkt verwendbar sind. Es wurde in Versuchen ohne Gleitmittel keine nachweisbare Auswirkung von Oberflächenfunktionalisierungen auf die Dichte an Nanodrähten gefunden.

Darüber hinaus ist im Stand der Technik bekannt, dass das Prinzip des lackbasierten Kontaktdrucks von Nanodrähten weiter miniaturisiert und optimiert werden kann, wenn die Öffnungen der Lackmaske in Bewegungsrichtung kleiner als die Länge der Nanodrähte wird. Die Modifikation des Verfahrens wird "nanocombing" genannt, da hierbei die absolute Ausrichtung bzgl. des Winkels um ca. eine Größenordnung verbessert werden konnte. Beim "nanocombing" berührt ein zu deponierender Nanodraht stets die funktionelle Unterlage ("Ankerpunkt") als auch den Fotolack. Wird der Lack wie im "lift-off-Prozess" entfernt, verbleiben nur "geankerte" Nanodrähte. Wird die Öffnung in Bewegungsrichtung jedoch deutlich kürzer als die Drahtlänge, dann überspannt der Nanodraht die Lacköffnung und "nanocombing" ist nicht mehr möglich.

Beim bekannten "nanocombing" wird der Kontaktdruck mit Gleitmitteln, zumeist mit Mineralöl, durchgeführt, welches nach dem Druck durch ein geeignetes Lösungsmittel (z.B. Oktan) wieder entfernt werden muss. Des Weiteren stellt die Entfernung der Lackschicht hier eine besondere Herausforderung dar, da die Nanodrähte trotz der sog. "Ankerpunkte" noch immer mit dem Lack verbunden sind. Wird der Fotolack nasschemisch entfernt, so können auch die geankerten Nanodrähte mit beseitigt werden, was die Depositionseffizienz negativ beeinträchtigt. Zudem ist die Entfernung der Lackschicht mit Acetondampf bekannt, was zwar schonender, aber sehr aufwendig ist. Problematisch am "nanocombing"-Verfahren bzw. auch am bisherigen Kontaktdruckverfahren ist ferner, dass insbesondere die Lackmaske und z.T. auch das Zielsubstrat selbst in Gegenwart eines Gleitmittels durch abrasive Effekte bei den zur Nanodrahtdeposition erforderlichen Anpressdrücken beschädigt werden können. Dieser Nachteil beschränkt die Skalierbarkeit, die Kompatibilität mit Mikrofabrikationstechniken und auch intrinsisch die minimale Stegbreite für lithographische Lackstrukturen z.B. beim "nanocombing", welche den mechanischen Einwirkungen noch standhalten können.

J. Yao et al. (Nature Nanotechnology, Bd. 8, Nr. 5, S. 329-335) offenbaren ein Verfahren zur Herstellung eines mit Nanodrähten strukturierten Substrats, bei dem ein Gleitmittel eingesetzt wird.

Ausgehend hiervon war es die Aufgabe der vorliegenden Erfindung, ein Verfahren zum Kontaktdruck von Nanodrähten auf ein Substrat bereitzustellen, auf dem ohne das Erfordernis einer Lackmaske bzw. deren Entfernung, ohne Einsatz von Gleitmittel und/oder ohne eine chemische Funktionalisierung seiner Oberfläche eine ortsspezifische und effiziente Deposition von Nanodrähten auf einem Substrat mit einem Kontaktdruckverfahren möglich ist.

Die Aufgabe wird gelöst durch das Verfahren gemäß Anspruch 1 zur Herstellung des Substrat gemäß Anspruch 12 und dessen Verwendung gemäß Anspruch 13.

Die abhängigen Ansprüche zeigen weitere vorteilhafte Ausgestaltungsformen auf.

Erfindungsgemäß wird ein Verfahren zur Herstellung eines mit Nanodrähten strukturierten Substrats bereitgestellt, umfassend die Schritte:
a) Bereitstellung eines Substrates, das an einer Oberfläche mindestens einen ersten Bereich mit ersten tribologischen Eigenschaften und mindestens einen zweiten Bereich mit zweiten tribologischen Eigenschaften enthält, wobei die ersten und zweiten tribologischen Eigenschaften verschieden sind und der erste Bereich den zweiten Bereich zumindest bereichsweise kontaktiert, wobei der zweite Bereich einen zum ersten Bereich unterschiedlichen Reibungskoeffizienten aufweist;
b) Anpressen eines Donorsubstrats enthaltend Nanodrähte mit einem bestimmten Anpressdruck auf den ersten Bereich des Substrats, sodass die Nanodrähte zumindest bereichsweise den ersten Bereich des Substrats kontaktieren; und
c) Bewegen des Donorsubstrats relativ zu dem Substrat in Richtung von dem ersten Bereich über mindestens den zweiten Bereich mit einer bestimmten Geschwindigkeit;
dadurch gekennzeichnet, dass in dem Verfahren kein Gleitmittel verwendet wird und nur durch das Bewegen des Donorsubstrats in Schritt c) und die unterschiedlichen tribologischen Eigenschaften der beiden Bereiche selektiv an lokal definierten Stellen des ersten und/oder zweiten Bereichs eine bestimmte Anzahl Nanodrähte abgelegt wird.

Insbesondere bedeutet die Verwendung von keinem Gleitmittel und keiner lithographischen Lackmaske, dass kein Gleitmittel und keine lithographische Lackmaske während des Verfahrens auf das Substrat aufgetragen wird und/oder von dem Substrat entfernt wird.

Ein wesentlicher Vorteil des erfindungsgemäßen Herstellungsverfahrens ist, dass ein mit Nanodrähten strukturiertes Substrat bereitgestellt werden kann, wobei verglichen mit Substraten aus dem Stand der Technik (z.B. Substraten im "nanocombing"-Verfahren) gezielt lokale tribologische Unterschiede auf den Substraten genutzt werden, um Nanodrähte lokal ohne Gleitmittel- und ohne lithographischen Lackmaskeneinsatz zu deponieren und ohne einen lithographischen Lack als Maske - im Gegensatz zu der "lift-off"-Technik - entfernen zu müssen.

Des Weiteren ist die Präzision des Verfahrens nicht durch eine Lackstabilität bestimmt und es werden keine aufwändigen Verfahren zur Lackentfernung benötigt, welche die Nanodrahtanordnung auf dem Substrat schädigen bzw. verändern können. Das Verfahren ist vollständig mit konventioneller Mikrofabrikation kompatibel und weist gegenüber dem Stand der Technik keine Kontamination durch Gleitmittel oder chemische (z.B. chemische kovalente) Oberflächenmodifikationen auf. Darüber hinaus ist es auch deutlich flexibler bzgl. der Materialauswahl, der Materialkombinationen sowie der funktionelten Gestaltung (z.B. lokale Topographie).

Folglich ist das Verfahren auch für gegenüber Gleitmitteln und/oder lithographischen Lacken empfindliche Substrate geeignet. Zudem ist die Abscheidung einzelner Nanodrähte in sehr schmale Bereiche mit deutlich höherer Ortsauflösung bzw. auch mit geringen Abständen als im "nanocombing"-Verfahren möglich. Eine solch selektive und feine Abscheidung von Nanodrähten auf einem Substrat ist mit den im Stand der Technik angewandten Lackmasken nicht möglich, da die mechanische Stabilität der Lackstege diese Feinheit unterbindet, bzw. die erforderlichen schmalen und kurzen Lacköffnungen zu einer zunehmenden Anhaftung der Nanodrähte am Lack und damit zu deren Beseitigung (damit keine Abscheidung auf dem Substrat) bei der erforderlichen Lackentfernung vom Substrat führt.

Während des Verfahrens interagieren die Nanodrähte über eine bestimmte Länge und Breite (d.h. Fläche) der einzelnen Nanodrähte mit dem ersten und/oder zweiten Bereich. Da der erste und zweite Bereich unterschiedliche tribologische Eigenschaften aufweisen, entsteht über beiden Bereichen eine für die Nanodrähte unterschiedliche hohe Reibungskraft, die bei Erreichen einer kritischen Höhe zur Ablösung bzw. Deposition eines Nanodrahts auf dem ersten bzw. zweiten Bereich des Substrats führt. Die wechselwirkende Fläche ändert sich durch die Relativbewegung der Nanodrähte zur Oberfläche kontinuierlich und kann daher lokal durch Änderung des Materials, der Topographie (z.B. lokale Höhe und/oder Form) und/oder Reibungskoeffizienten der Oberfläche (erster und/oder zweiter Bereich) beeinflusst werden. Das Anwendungsspektrum des erfindungsgemäßen Verfahrens reicht von Nanodraht-Flächenabscheidungen bis hin zur Positionierung eines einzelnen Nanodrahts. Darüber hinaus kommt das vorgestellte Kontaktdruck-Verfahren ohne Lackmasken zur lokalen Begrenzung der Deposition sowie auch ohne Gleitmittel während des Kontaktdrucks aus.

Die Bewegung des Donorsubstrats mit den Nanodrähten relativ zum Substrat kann prinzipiell in jeder Raumrichtung (entlang der Länge, entlang der Breite und/oder senkrecht zur Fläche des Substrats) individuell und auch nichtlinear erfolgen, was zu individuellen Bewegungsmustern führt und eine nichtlineare Abscheidung von Nanodrähten bewirken kann. Die Bewegung kann manuell oder mit Hilfe einer Antriebstechnik realisiert werden, eventuell zusätzlich unterstützt durch eine Regelungstechnik. Der Anpressdruck der Reibpartner kann statisch oder dynamisch erfolgen und prinzipiell mit dem Steuer- und Antriebssystem gekoppelt sein.

Das vorgestellte Verfahren nutzt mindestens eine der folgenden Gegebenheiten zur selektiven und ortsspezifischen Deposition von Nanodrähten auf einem Substrat:
1. Die tribologische Wechselwirkung zwischen Nanodrähten und Substrat während der Bewegung beeinflusst die Depositionswahrscheinlichkeit eines Nanodrahts beim Kontaktdruck, wobei lokale Variationen der tribologischen Wechselwirkung zur lokalen Deposition von Nanodrähten ausgenutzt werden;
2. Unterschiedliche Materialien weisen eine unterschiedliche tribologische Wechselwirkung mit einem bestimmten Nanodraht auf;
3. Bei gleichen Kontaktdruckparametern, wie Druck und Geschwindigkeit, ist die deponierte Nanodrahtdichte lokal unterschiedlich, wenn auch die lokalen tribologischen Wechselwirkungen verschieden sind;
4. Die Dichte an Nanodrähten auf dem Donorsubstrat und die Relativgeschwindigkeit können die Abscheiderate an Nanodrähten beeinflussen (tribologischer Zusammenhang);
5. Eine lokale Topographie-Änderung auf dem Substrat führt zu einer lokalen Änderung der tribologischen Wechselwirkung zwischen Nanodrähten und Substrat;
6. Durch einen lokal vordefinierten Einsatz von topographischen Strukturen kann der Ort der Deposition der Nanodrähte gezielt gesteuert werden (Fängerstrukturen), wodurch die Nanodrähte auch gezielt in einer von der Linearität abweichenden Geometrie (z.B. gekrümmt) auf dem Substrat abgelegt werden können;

Das erfindungsgemäße Verfahren kann dadurch gekennzeichnet sein, dass die unterschiedlichen tribologischen Eigenschaften des ersten und zweiten Bereichs über mindestens eine Fängerstruktur erreicht werden, die der erste und/oder zweite Bereich enthält oder daraus besteht, oder die optional auf diesem aufgebracht wird.

### Die mindestens eine Fängerstruktur kann

a) im ersten Bereich ein Material enthalten oder daraus bestehen, das zu einem Material des zweiten Bereichs identisch oder verschieden ist;
b) im zweiten Bereich ein Material enthalten oder daraus bestehen, das zu einem Material des ersten Bereichs identisch oder verschieden ist;
c) im ersten Bereich eine topographische Struktur enthalten oder daraus bestehen, die zu der topographischen Struktur des zweiten Bereichs identisch oder verschieden ist; und/oder
d) im zweiten Bereich eine topographische Struktur enthalten oder daraus bestehen, die zu der topographischen Struktur des ersten Bereichs identisch oder verschieden ist.

Die mindestens eine Fängerstruktur kann ein Metall, eine Metallverbindung, ein Halbmetall, eine Halbmetallverbindung, einen Kunststoff und/oder Kohlenstoff, insbesondere Gold, Pt, Al, Si, Ge, SiO₂, Si₃N₄, Diamant, Al₂O₃ und/oder TiN, enthalten oder daraus bestehen. Besteht die Fängerstruktur im zweiten Bereich beispielsweise aus Si₃N₄, und der erste Bereich besteht aus Gold, so erfolgt bei bestimmten Nanodrähten (z.B. Nanodrähten aus Silizium), bestimmtem Anpressdruck, bestimmter Geometrie der Fängerstruktur und bestimmter Bewegungsgeschwindigkeit der Nanodrähte die Abscheidung nur im Si₃N₄-Bereich. Die Materialabhängigkeit wird z.B. durch die unterschiedlichen Adhäsions- sowie Kohäsionskräfte zwischen den eingesetzten Reibpartnern bestimmt. Folglich kann durch die Wahl unterschiedlicher Materialien, und auch ihrer unterschiedlichen topographischen Struktur (z.B. Höhe), auf dem Substrat die Depositionsdichte von Nanodrähten vorbestimmt werden. Wird die Kontaktdruckeffizienz auf den Materialien SiO₂, Gold- und Si₃N₄ verglichen, so zeigt sich, dass für Nanodrähte aus Silizium bei einem bestimmten, gleichen Auflagedruck auf Si₃N₄ eine hohe, auf Gold eine geringere und auf SiO₂ praktisch keine Deposition von Nanodrähten erreicht wird. Für SiO₂ wird erst bei einem deutlich erhöhten Auflagedruck (z.B. Faktor 3 höher) eine Nanodrahtabstreifung erreicht, die jedoch von stark abrasiven Oberflächenschädigungen begleitet ist.

In einer bevorzugten Ausführungsform ist die topographische Struktur ausgewählt aus der Gruppe bestehend aus flächigen, linearen und/oder punktuellen topographischen Strukturen. Bevorzugt enthält die topographische Struktur eine Dreiecksform, eine Quaderform, eine Zylinderform, eine Kugelform, eine Halbkugelform, eine Erhöhung und/oder eine Vertiefung, oder besteht daraus.

Der einfachste topographische Unterschied stellt hierbei eine Stufe im zweiten Bereich als Höhenunterschied in Bewegungsrichtung dar, z.B. mit einer Höhe in der Größenordnung des Durchmessers der Nanodrähte. Die Stufe kann positiv oder negativ sein d.h. relativ zum ersten und/oder zweiten Bereich erhöht oder vertieft sein. Wird die Stufe im zweiten Bereich aus dem gleichen Material wie das Material des ersten Bereichs gefertigt (erstes Material = zweites Material), so liegt eine Homostruktur vor, die den Kontaktdruck hauptsächlich geometrisch dominiert. Der zweite Bereich kann auch einen zum ersten Bereich unterschiedliche Oberflächenrauigkeit aufweisen, was einen unterschiedlichen Reibungskoeffizienten bewirkt.

Wird die Stufe im zweiten Bereich aus einem anderen Material als das Material des ersten Bereichs gefertigt (erstes Material ≠ zweites Material) liegt eine Heterostruktur vor und es können zusätzlich Materialeffekte (z.B. unterschiedliche materialspezifische Reibungskoeffizienten) ausgenutzt werden. Es können beispielsweise auf dem Substrat mindestens zwei unterschiedliche Materialoberflächen planar aneinander grenzen (Höhenunterschied zwischen den Materialoberflächen ist z.B. ≤ 10 nm). Die unterschiedlichen Materialien bewirken, dass im ersten und zweiten Bereich das Abstreifen der Nanodrähte mit unterschiedlichen Dichten erfolgt.

In einer bevorzugten Ausführungsform enthält mindestens eine Fängerstruktur Nanopartikel (z.B. im Wesentlichen runde Nanopartikel oder Nanopartikel in Halbkugelform) oder besteht daraus. Diese können z.B. in Schritt a) des Verfahrens auf den ersten und/oder zweiten Bereich zumindest bereichsweise aufgebracht werden oder diese können (bereits) aufgebracht sein. Die Nanopartikel können einen Durchmesser von 2 nm bis 200 nm aufweisen, bevorzugt 20 bis 100 nm (gemessen mit Elektronenmikroskopie).

In einer weiteren bevorzugten Ausführungsform sind mindestens zwei (optional mindestens 3, 4, 5, 6, 7, 8, 9 oder 10) Fängerstrukturen im ersten und/oder zweiten Bereich enthalten oder dieser besteht daraus, oder sie werden auf diesem aufgebracht, wobei bevorzugt jeweils zwei Fängerstrukturen einen Abstand zueinander aufweisen, der im Wesentlichen dem Durchmesser und/oder der Länge eines Nanodrahtes des Donorsubstrats entspricht.

Die Nanodrähte können in einer von der Linearität abweichenden Geometrie auf dem Substrat abgelegt werden, bevorzugt in einer gekrümmten Geometrie. Die Ablegung in einer von der Linearität abweichenden Geometrie kann erreicht werden durch
i) Bewegen des Donorsubstrats relativ zu dem Substrat in unterschiedlichen Richtungen relativ zum ersten Bereich und/oder zweiten Bereich einer bestimmten Geschwindigkeit; und/oder
ii) Bewegen des Donorsubstrats über mindestens eine Fängerstruktur (optional mindestens 2, 3, 4, 5, 6, 7, 8, 9 oder 10 Fängerstrukturen), die der erste und/oder zweite Bereich enthält oder daraus besteht, oder die optional auf diesem aufgebracht wird.

Das vorgestellte Kontaktdruckverfahren kann damit auch sequentiell unter Variation des Winkels erfolgen (Variation der Bewegungsrichtung in Richtung der Länge des Substrats, Breite des Substrats und/oder senkrecht zur Fläche des Substrats), wodurch gekreuzte Nanodrahtanordnungen generiert werden können. Bevorzugt wird daher in dem erfindungsgemäßen Verfahren in Schritt c) die relative Bewegungsrichtung geändert und/oder Schritt c) mindestens einmal wiederholt. Auch mehr als eine Fängerstruktur auf dem Substrat ermöglicht eine definierte lokale Abscheidung von Nanodrähten. Bei geeigneter Wahl des vordefinierten Abstands zwischen z.B. zwei gegenüberliegenden Fängerstrukturen kann zudem die Länge oder Breite (Durchmesser) lokal abgeschiedener Nanodrähten beeinflusst werden. Bei einem Abstand im Bereich des Durchmessers der Nanodrähte kann auf dem erfindungsgemäßen Substrat gezielt und an lokal definierter Stelle ein einzelner Nanodraht auf dem Substrat abgeschieden werden. Bevorzugt wird der mindestens eine Nanodraht des Substrats zumindest bereichsweise zwischen mindestens zwei gegenüberliegenden Fängerstrukturen abgelegt.

In Schritt a) kann der erste und/oder zweite Bereich des Substrats über eine Mikrofabrikationstechnik hergestellt werden, bevorzugt über Photolithographie, Elektronenstrahllithographie, "lift-off"-Technik, PVD, CVD und ALD und/oder trocken- und nass-chemisches Ätzen.

Im ersten Bereich und/oder zweiten Bereich oder zwischen beiden Bereichen kann mindestens ein Graben erstellt werden oder angeordnet sein, wobei der Graben bevorzugt zumindest bereichsweise von mindestens einem Nanodraht überspannt wird und/oder mindestens ein Nanodraht zumindest bereichsweise in dem Graben abgelegt wird, insbesondere die Länge des mindestens einen Grabens bevorzugt weniger als die halbe Länge der Nanodrähte beträgt.

### Die Nanodrähte können

i) ein Metall, Metallverbindungen, Halbmetall, Halbmetallverbindungen, Kohlenstoff und/oder Kohlenstoffverbindungen enthalten oder daraus bestehen, bevorzugt Silizium, ZnO und/oder Kohlenstoffnanoröhrchen; und/oder
ii) vor Schritt b) über einen Vakuum-Prozess, bevorzugt einen Goldkatalysierten "vapour-liquid-solid"-Prozess, oder über einen, trockenen oder nasschemischen Prozess hergestellt werden; und/oder
iii) eine Länge von 100 nm bis 1 mm, bevorzugt 1 µm bis 500 µm, besonders bevorzugt 5 µm bis 200 µm, insbesondere 10 µm bis 100 µm, aufweisen; und/oder
iv) einen Durchmesser von 1 nm bis 5 µm, bevorzugt 2 nm bis 500 nm, besonders bevorzugt 5 nm bis 200 nm, insbesondere 10 nm bis 100 nm, aufweisen; und/oder
v) zumindest bereichsweise eine konische, zylindrische, gekrümmte und/oder eckige Struktur aufweisen; und/oder
vi) zumindest bereichsweise oder vollständig metallisch leitend, p-leitend, n-leitend, intrinsisch leitend und/oder nichtleitend sein.

Der Anpressdruck kann z.B. in einem Bereich von 5 kPa bis bis 100 kPa, bevorzugt 8 kPa bis 80 kPa, besonders bevorzugt 10 kPa bis 60 kPa, insbesondere 12 kPa bis 50 kPa, liegen. Ein höherer Anpressdruck bedeutet auch eine Erhöhung der Flächenwechselwirkung von Nanodrähten und Substrat während des Verfahrens, was eine höhere Abscheidewahrscheinlichkeit zur Folge hat.

Untersuchungen zur Oberflächenrauigkeit an beispielhaft eingesetzten Materialien Si₃N₄ und SiO₂ zeigen, dass hierbei SiO₂ mit ca. 12 nm (RMS) deutlich rauer war als Si₃N₄ mit ca. 2 nm (RMS). Eine größere Rauigkeit würde erst einmal grundlegend die absolute Kontaktfläche verkleinern (Bowden-Tabor-Modell) und stellt damit eine Begründung, neben reinen Materialeffekten, für das unterschiedliche Verhalten der verschiedenen Materialien dar.

In dem Verfahren kann die Geschwindigkeit der Bewegung über das Substrat z.B. 1 bis 20 mm/s, bevorzugt 2 bis 15 mm/s, besonders bevorzugt 3 bis 10 mm/s, insbesondere 4 bis 8 mm/s, betragen. Während des Verfahrens kann es auftreten, dass das Ursprungssubstrat an Nanodrähten verarmt. Der kontinuierliche Verlust an Nanodrähten erzeugt intrinsisch einen Gradienten in der abgeschiedenen Nanodrahtdichte mit zunehmender Entfernung vom Startpunkt des Verfahrens. Dies kann unter Umständen ein Vorteil sein, wenn mit steigender Entfernung eine geringere Abscheidedichte an Nanodrähten gewünscht wird. Durch Kontrolle der Parameter Anpressdruck und Geschwindigkeit kann dieser Effekt intrinsisch ausgeglichen werden.

Ferner wird erfindungsgemäß ein Substrat bereitgestellt, enthaltend an einer Oberfläche
a) mindestens einen ersten Bereich mit ersten tribologischen Eigenschaften;
b) mindestens einen zweiten Bereich mit zweiten tribologischen Eigenschaften, wobei der zweite Bereich zumindest bereichsweise den ersten Bereich kontaktiert und der zweite Bereich einen zum ersten Bereich unterschiedlichen Reibungskoeffizienten aufweist; und
c) mindestens einen Nanodraht, der den ersten und/oder zweiten Bereich zumindest bereichsweise kontaktiert;
wobei der erste und zweite Bereich unterschiedliche tribologische Eigenschaften aufweisen und der erste und/oder zweite Bereich selektiv an lokal definierten Stellen eine bestimmte Anzahl Nanodrähte enthalten, dadurch gekennzeichnet, dass das erfindungsgemäße Substrat über das erfindungsgemäße Verfahren herstellbar ist (bzw. hergestellt wird).

Das Substrat kann mindestens einen Graben enthalten, der zwischen dem ersten und zweiten Bereich oder in dem ersten Bereich und/oder in dem zweiten Bereich angeordnet ist, bevorzugt den ersten und/oder zweiten Bereich kontaktiert. Den Graben kann mindestens ein Nanodraht überspannen.

Das Substrat kann mindestens einen Nanodraht enthalten, der bevorzugt den ersten und/oder zweiten Bereich kontaktiert und besonders bevorzugt zwischen den mindestens zwei, bevorzugt zwischen mehreren, gegenüberliegenden Fängerstrukturen angeordnet ist. Der mindestens eine Nanodraht kann eine von der Linearität abweichende Geometrie aufweisen, bevorzugt zumindest bereichsweise gekrümmt sein.

Das erfindungsgemäße Substrat kann mindestens ein Merkmal aufweisen, das oben für das Substrat und seine Bestandteile im Zusammenhang mit dem erfindungsgemäßen Verfahren genannt wurde.

Es wird darüber hinaus die Verwendung des erfindungsgemäßen Substrats in der Analytik, Materialsynthese, Mikroelektronik, Mikrosystemtechnik und/oder Mikrosensorik vorgeschlagen.

Anhand der nachfolgenden Figuren und Beispiele soll der erfindungsgemäße Gegenstand näher erläutert werden, ohne diesen auf die hier dargestellten spezifischen Ausführungsformen einzuschränken.

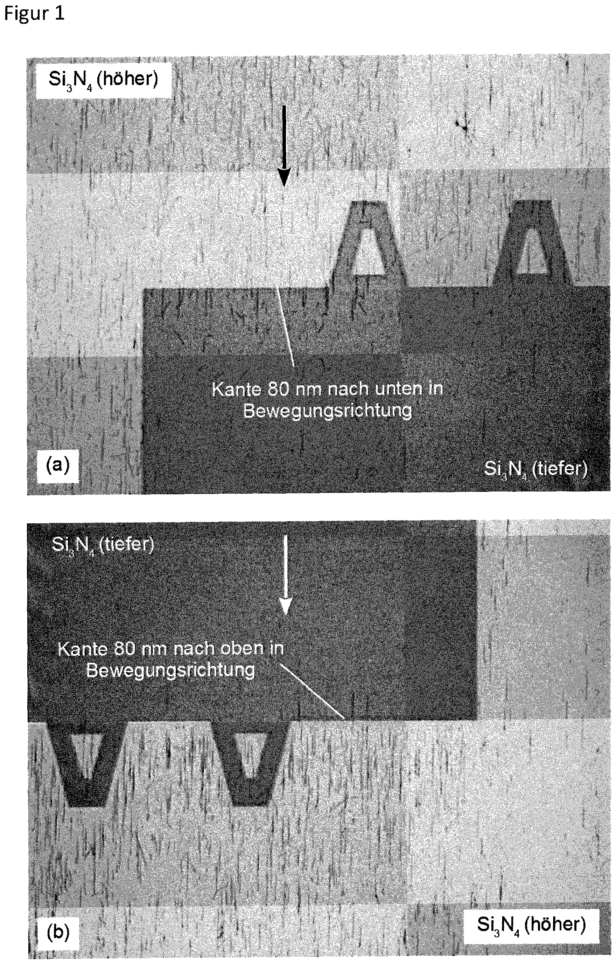

Figur 1 a) und b) zeigt den Einfluss einer Stufe mit einer Höhe von ca. 80 nm für Si₃N₄. Stufen erzeugen eine lokal stärkere tribologische Wechselwirkung und damit eine lokal höhere Dichte an deponierten Nanodrähten auf den erhabenen Flächen. Dies ist unabhängig von der Bewegungsrichtung.

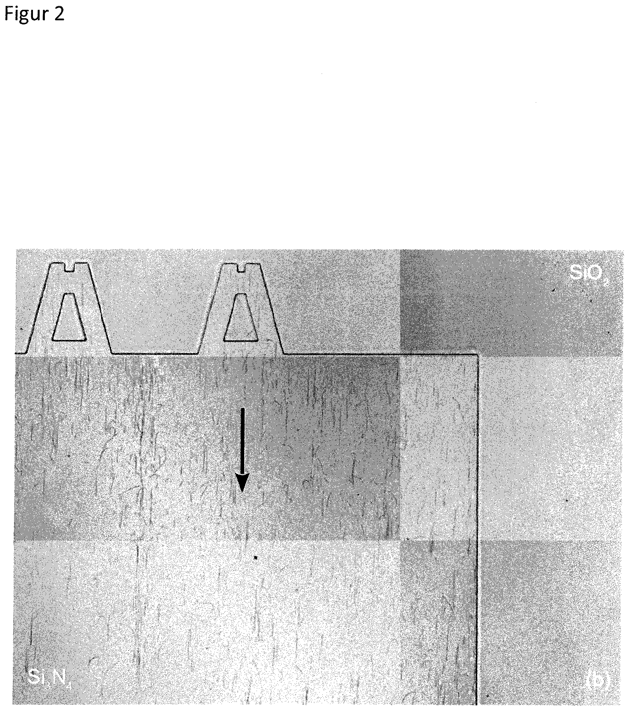

Figur 2 zeigt einen Kontaktdruck über eine SiO₂-Si₃N₄-Oberfläche. Hier wird mit nahezu einer Ausbeute von 100% eine rein lokale Deposition von Nanodrähten auf dem Si₃N₄ beobachtet.

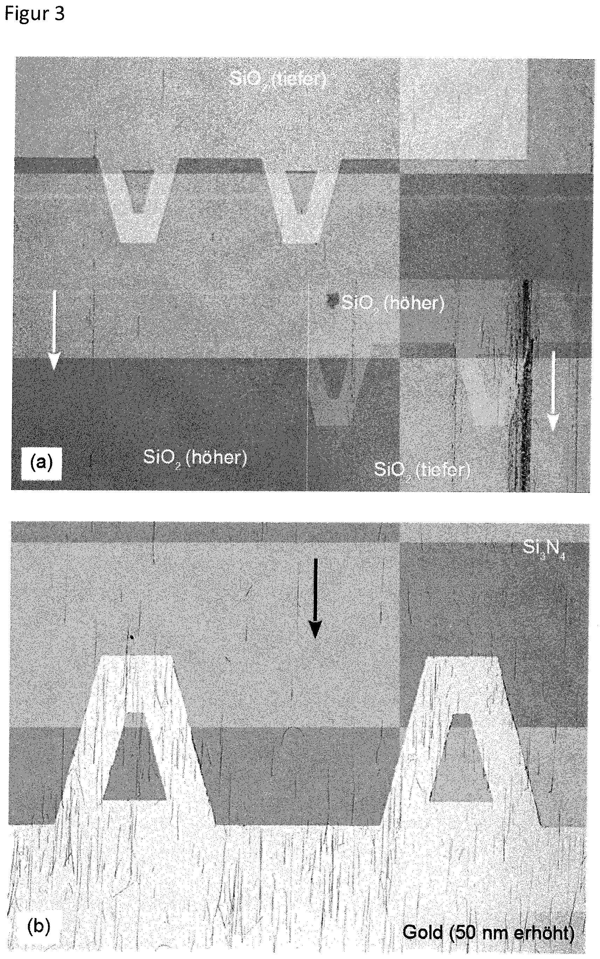

Figur 3a) zeigt, dass bei einem ersten und zweiten Bereich aus SiO₂ und einer Stufenhöhe von ca. 80 nm keine starke Veränderung der Abscheiderate eintritt. Fig. 3b) zeigt einen deutlichen Unterschied in der Abscheiderate für den Fall, dass zwar eine im Vergleich zu Fig. 3a) niedrigere Höhenstufe zwischen den Bereichen vorherrscht (50 nm statt 80 nm), aber der erste und zweite Bereich aus einem unterschiedlichen Material sind (erster Bereich Si₃N₄, zweiter Bereich Gold).

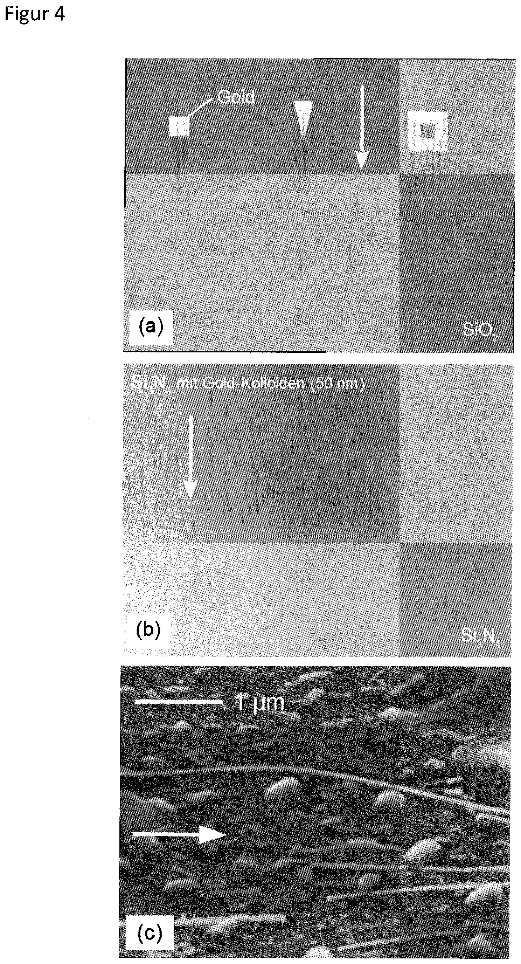

Figur 4a) zeigt die Deposition von Nanodrähten auf einem Substrat, dessen erster Bereich aus SiO₂ besteht und dessen zweiter Bereich eckige Strukturen aus Gold aufweist. Es wird beobachtet, dass sich die Nanodrähte direkt hinter der eckigen Goldstruktur (Goldstruktur hat eine Höhe und damit Stufe von 50 nm) ablegen. In Fig. 4b) ist die drastisch erhöhte lokale Abscheidung von Nanodrähten auf einem Substrat dargestellt, dessen erster Bereich aus Si₃N₄ besteht und dessen zweiter Bereich aus runden Goldstrukturen (Gold-Nanopartikel) besteht. Fig. 4c) zeigt eine REM-Aufnahme der Oberfläche im Bereich der Gold-Nanopartikel. Es wird deutlich, dass die Nanodrähte vollständig auf dem Si₃N₄ und zwischen den Gold-Nanostrukturen deponiert werden. Auch die Abweichung von der Linearität bei der Deposition wird hier bereits deutlich.

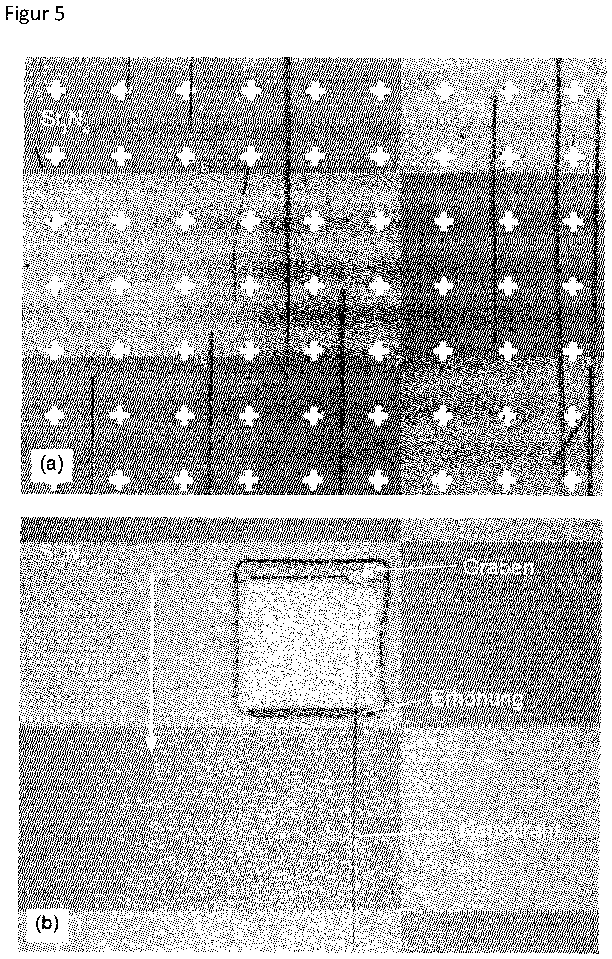

Figur 5a) zeigt die spezifische lokale Deposition konischer Nanodrähte zwischen den Goldstrukturen (Struktur in "+"-Form) auf Si₃N₄. In Fig. 5b) ist dagegen die Abscheidung eines Nanodrahts auf einer Stufe aus SiO₂ (zweiter Bereich) auf Si₃N₄ (erster Bereich) gezeigt (Stufenhöhe ca. 450 nm). Der Graben existiert fertigungsbedingt. Dadurch wird deutlich, dass die tribologischen Eigenschaften des Materials SiO₂, das eine geringe Affinität zu den verwendeten Nanodrähten aufweist, durch Einfügen einer topographischen Struktur aus diesem Material mit geeigneter Höhe zu einer erfolgreichen Abscheidung von Nanodrähten führen kann. Somit können "wenig affine Bereiche" durch Anheben ihres Niveaus relativ zu benachbarten Bereichen auch zu Trägern von Nanodrähten werden.

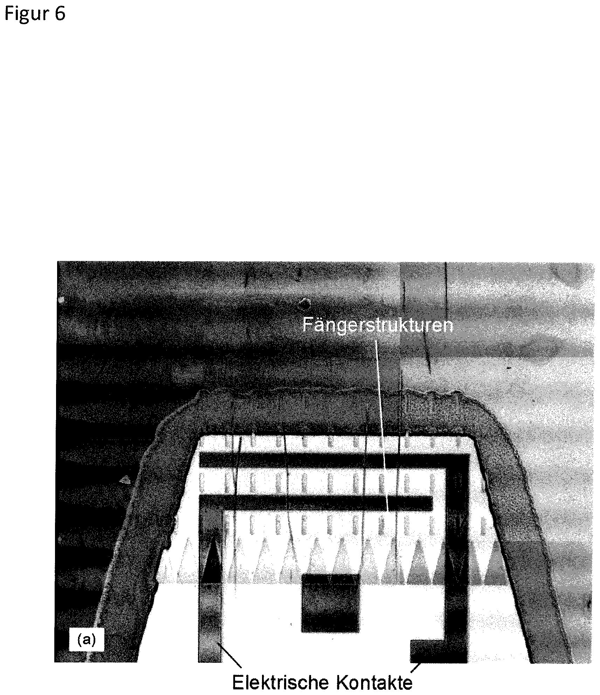

Figur 6 zeigt eine funktionelle elektrische Struktur mit vier integrierten Nanodrähten. Die Nanodrähte wurden mit Hilfe von definierten Fängerstrukturen lokal deponiert und anschließend mikrotechnologisch integriert. Auf Chips mit 21 funktionellen Feldern (7x3 Matrix) konnte eine Ausbeute von bis zu 80% in der Fertigung funktioneller Nanodrahtsensoren für die Kraftmikroskopie erreicht werden.

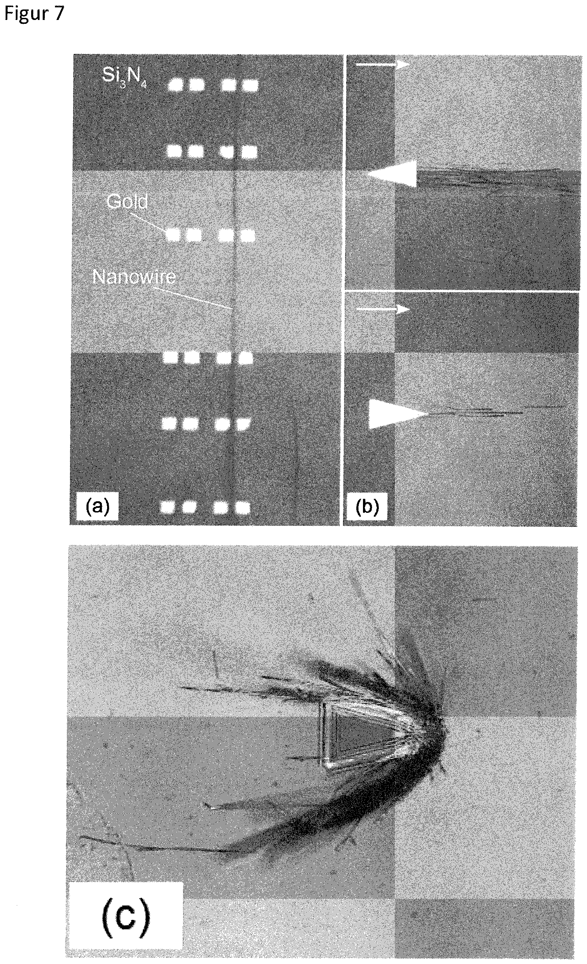

Figur 7a) zeigt das Grundprinzip einer Fängerstruktur mit Breitenfilter, also die Abscheidung von Nanodrähten in den Zwischenräumen der Fängerstrukturen, die hier als goldene Rechtecke ausgeführt sind. In Fig. 7b) ist der Einfluss der geometrischen Form des zweiten Bereichs - hier ein Dreieck mit einer Höhe von ca. 50 nm - auf die Verteilung deponierter Nanodrähte gezeigt, wobei deutlich wird, dass sich bei einer Bewegungsrichtung des Donorsubstrats von der Basis des Dreiecks zu dessen Spitze vor allem an der Spitze Nanodrähte abscheiden. In Fig. 7c) ist die zufällige, unspezifisch nicht-lineare Deposition von Nanodrähten auf einer 1 µm hohen dreieckigen Lackstruktur dargestellt.

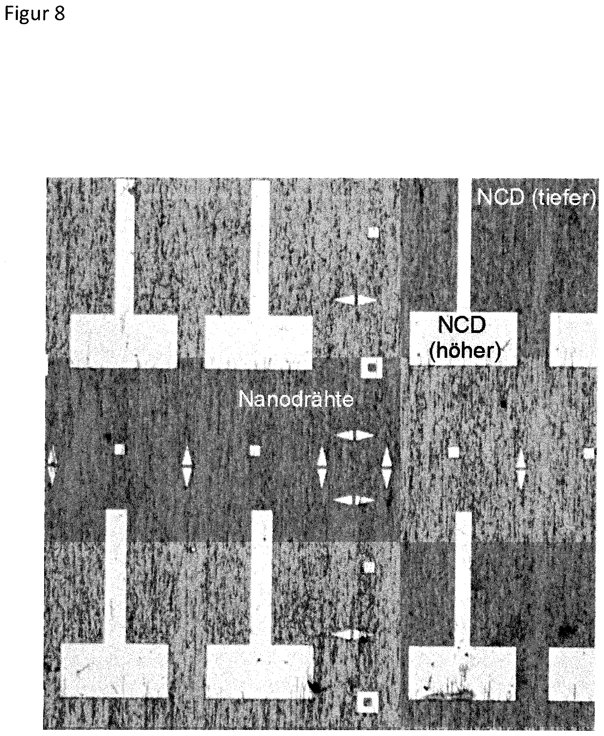

Figur 8 zeigt eine nanokristalline Diamantschicht, bei der Stufen mit 1 µm Höhe erzeugt wurden. Beim Kontaktdruck mit Si-Nanodrähten zeigte sich, dass bei diesem Material die Abscheidung bevorzugt auf den tiefer liegenden Flächen erfolgt. Die Ausnutzung der unterschiedlichen tribologischen Eigenschaften erster und zweiter Bereiche auf einem Substrat ist also universell möglich und nicht auf bestimmte Substrate limitiert.

### Beispiel 1 - Höhenunterschied und identisches Material der Bereiche

Die Fig. 1a und 1b zeigt beispielhaft das System Si₃N₄ bei dem entweder der erste Bereich (Fig. 1b) oder der zweite Bereich (Fig. 1a) aus Si₃N₄ 80 nm nach unten verlagert wurde. Es ist hierbei deutlich zu erkennen, dass für diesen Fall auf allen erhabenen Oberflächen eine deutlich höhere Nanodrahtdichte abgeschieden wurde. Die Bewegungsrichtung ist jeweils in der Abbildung mit einem Pfeil gekennzeichnet. Während im Falle von Si₃N₄ ein sehr großer Einfluss der Topographie vorliegt, ist dieser bei flächigen Strukturen aus SiO₂ nicht zu erwarten und konnte auch nicht nachgewiesen werden.

Da bei SiO₂ trotz einer Erhöhung des Auflagegewichts von 60 g auf 200 g bzgl. 0,45 cm² als Fläche generell kaum ein Abtrag verzeichnet werden konnte, führt eine Verringerung der effektiven Fläche durch Stufenbildung kaum zu einer signifikanten Erhöhung der Depositionsrate (siehe Fig. 3a). Hier tritt zudem eine für SiO₂ mit 200 g Auflagegewicht typische Oberflächenschädigung auf.

Anders verhält sich der Fall bei einer Kombination der Materialien Gold und Si₃N₄ mit einer Stufe. Wird eine Stufe aus Gold auf Si₃N₄ aufgebracht, so erfolgt jetzt eine bevorzugte Abscheidung auf dem höher gelegenem Gold, während tiefer gelegenes Si₃N₄ nur eine sehr geringe Nanodrahtdichte aufweist (siehe Fig. 3b).

Eine signifikante Verringerung der Fläche erhabener Oberflächenstrukturen ist prinzipiell von einer Erhöhung der lokalen Auflagekraft begleitet, was zu einer erhöhten Nanodrahtdichte auf Erhebungen führen kann. Dieser Effekt ist für das System mit Silizium-Nanodrähten auf dem hier verwendeten Si₃N₄-Substrat besonders ausgeprägt.

### Beispiel 2 - Höhenunterschied und verschiedenes Material der Bereiche

Zusätzliche Freiheitsgrade können durch den Einsatz von Bereichen aus unterschiedlichen Materialien (Heterostrukturen wie z.B. Si₃N₄/SiO₂) sowie durch eine Verringerung der lateralen Strukturgröße der funktionellen Bereiche generiert werden. Kritische Größenordnungen der Strukturgeometrien sind dabei intrinsisch die Länge und der Durchmesser der Nanodrähte. Neben der reinen Erhöhung der Auflagekraft spielt auch die dynamische Wechselwirkung eine große Rolle, die insbesondere in Erscheinung tritt, wenn die laterale Dimension der Struktur kleiner als die Länge der Nanodrähte wird. Überstreicht ein Nanodraht nur mit einem Teil seiner Länge eine erhöhte Struktur, so werden die Nanodrähte dennoch effektiv von der Unterlage entkoppelt. Eine Reibungskraft in kritischer Höhe kann somit kaum entstehen, nur eine mechanische Deformation der Nanodrähte gemäß dem Modell einer gespannten Feder.

Allgemein gilt, je geringer die laterale Ausdehnung der Struktur und je geringer die tribologische Aktivität des Stufenmaterials, desto unwahrscheinlicher ist die Deposition von Nanodrähten auf der Stufe. Verlässt der Nanodraht eine lokal begrenzte Erhöhung durch seitliches Abgleiten oder nach vollständigem Überstreichen, so scheint die kurze Vertikalbewegung, induziert durch die Freisetzung der Deformationsenergie, zu einer größeren tribologischen Wechselwirkung zu führen als bei reiner Gleitreibung. Der kritische Reibungswert wird überschritten und der Nanodraht mit erhöhter Wahrscheinlichkeit hinter oder neben der Erhöhung deponiert. Dieser Mechanismus ist äußerst effizient und resultiert sogar in einer lokalen/selektiven Abscheidung auf SiO₂. Nanodrähte können hierbei in signifikanter Menge hinter Goldstrukturen verschiedener Geometrien auf dem ca. 50 nm tiefer liegenden, sonst zur Ablagerung eher ungeeigneten, SiO₂ deponiert werden.

Auch für andere Unterlagen wie z.B. Si₃N₄ ergibt sich eine größere Abscheidung hinter den Goldstrukturen, allerdings auch eine ausgeprägte Abscheidung in der tieferen Fläche, wie für das Material Si₃N₄ zu erwarten.

Das für den generellen Mechanismus insbesondere die Höhe der Stufe, aber nicht deren laterale Dimension maßgeblich ist, stellt Fig. 4a und 4b dar. Hierbei wurden Gold-Nanopartikel mit einem Durchmesser von ca. 50 nm in einem lokalen Gebiet auf die Oberfläche von Si₃N₄ aufgebracht. Nach dem Kontaktdruck wird die verstärkende Wirkung derartiger Nanopartikel-Erhebung an einer lokal deutlich erhöhten Dichte an Nanodrähten exakt im Gebiet der Gold-Nanopartikel deutlich (Fig. 4b). Mittels Elektronenmikroskopie zeigt sich, dass die Nanodrähte allerdings nicht auf dem Gold abgeschieden werden bzw. daran hängen bleiben, sondern zwischen den Strukturen, auch nicht linear, deponiert sind (Fig. 4c). Dieser Effekt wird auch bei mikrotechnologisch erzeugten Strukturen unabhängig von der Nanodrahtmorphologie beobachtet (Fig. 5a).

Um die Allgemeingültigkeit der hier vorgestellten Prinzipien zu erweitern, wurden Bereiche aus SiO₂, inklusive einer SiO₂-Stufe, in einem Gebiet mit Si₃N₄ lithographisch erzeugt. Im Gegensatz zu den bisherigen Stufen von 50 bis 100 nm waren diesen Stufen allerdings 400 nm bis 500 nm hoch. Wie zu erwarten wurde eine Änderung des Kontaktdrucks in diesen Bereichen beobachtet. Die Nanodrähte bleiben hierbei an der hohen Stufe hängen, sodass die Nanodrähte bevorzugt auf der SiO₂-Stufe deponiert wurden (Figur 5b).

### Beispiel 3 - Höhenunterschied durch spezielle Stufenform

Des Weiteren existiert auch ein Einfluss der lateralen Geometrie selbst. Die Form der Struktur kann hierbei maßgeblich die lokale Wahrscheinlichkeit einer Nanodrahtabscheidung beeinflussen. Dies zeigt sich besonders deutlich bei Dreiecksstrukturen (siehe Fig. 4a).

### Beispiel 4 - Grabenstruktur zwischen den Bereichen

Es ist mit dem erfindungsgemäßen Verfahren möglich, Grabenstrukturen in dem Substrat mit Nanodrähten zu überspannen. Es wurde gefunden, dass ein Graben auch noch dann überspannt werden kann, wenn dieser bereits in seiner Breite gleich der halben Länge der Nanodrähte ist (z.B. Nanodrahtlänge 40 µm, Grabenbreite 20 µm). Hierbei ist es nicht zwingend erforderlich, dass die beiden Grabenseiten planar ausgerichtet sind.

### Beispiel 5 - Konkurrenz von Höhenunterschied und versch. Materialien

Eine zuvor im Substrat definierte Stufe kann durch Einsatz weiterer funktioneller Strukturen quasi überschrieben werden, z.B. kann eine erhöhte Stufe durch Hinzufügen einer weiteren Stufe größerer Höhe in ihrer tribologischen Wechselwirkung abgeschwächt und sogar neutralisiert werden. Entsprechendes gilt für eine erniedrigte Stufe. Beispielsweise kann eine erniedrigte Stufe, die unter bestimmten Bedingungen keine Abscheidung von Nanodrähten bewirkt durch das Aufbringen von Nanopartikeln mit großem Durchmesser zu einer Stufe werden, auf der Nanodrähte abgeschieden werden. Durch diese (temporäre) Modifikation der Stufe wird diese quasi in ihrer ursprünglichen Wirkung "überschrieben".

Dieser Umstand kann verfahrenstechnisch genutzt werden, wodurch sich zusätzliche Freiheitsgrade in der Gestaltung von Strukturen zum oberflächengesteuerten Kontaktdruck ergeben.

### Beispiel 6 - Fängerstrukturen auf dem Substrat

Fängerstrukturen erlauben eine gezielte und gerichtete lokale Abscheidung eines Nanodrahts. Hierbei stellen die Fängerstrukturen beispielsweise mikrotechnologisch hergestellte Gold-Strukturen dar, zwischen denen während des Verfahrens zum Kontaktdruck von Nanodrähten eine gezielte Abscheidung von Nanodrähten stattfindet (siehe z.B. Fig. 5a).

Auch lokal begrenzte Bereiche von lokalen Rauhigkeitsänderungen (hier Gold-Nanopartikel) und laterale Geometrien (z.B. Dreiecksstrukturen) können in den Bereich der Fängerstrukturen fallen. Fängerstrukturen umfassen folglich alle lokal vordefinierten Strukturen, die aus einem anderen Material bestehen und/oder eine anderen Topographie/Geometrie aufweisen und somit zu einer lokalen Änderung der tribologischen Eigenschaften des Substrats und damit zu einer lokal veränderten Depositionswahrscheinlichkeit der Nanodrähte führen.

Als ein Anwendungsbeispiel ist in Fig. 6 die Ausstattung von Sonden zur Kraftmikroskopie mit einem Nanodraht im Bereich der Sondenspitze dargestellt. Hierbei wurden 3x7 Sonden parallel mit konventioneller Fotolithographie gefertigt. Für eine funktionelle Sonde ist es erforderlich, dass ein Nanodraht in einem engen, lokal definierten Bereich abgelegt wird, damit alle Strukturen anschließend parallel ohne individuelle Anpassung elektrisch kontaktiert werden können. Für diese spezielle Anwendung besteht zusätzlich das Erfordernis, dass der Nanodraht über die Struktur hinausreicht. In den Tests wurde bzgl. den 21 Sonden eine Ausbeute von bis zu 80 % erzielt.

Je nach Design des Materialsystems kann zwischen positiven und negativen Fängern unterschieden werden. Bei einer negativen Fängerstruktur erfolgt die Nanodrahtdeposition bevorzugt auf die Unterlage zwischen die Strukturen (z.B. Gold auf Si₃N₄, Fig. 7a), wobei die Nanodrahtdeposition im Gegensatz dazu bei einer positiven Fängerstruktur auf der Struktur erfolgt (z.B. Si₃N₄ auf SiO₂, Fig. 2). Darüber hinaus gibt es auch neutrale Strukturen, bei denen beide Eigenschaften beobachtet werden können (Gold auf SiO₂, Fig. 4a).

Aus der Modellvorstellung einer kritischen Wechselwirkungslänge bzw. Fläche ergibt sich konsequent, dass das oberflächengesteuerte Kontaktdruckverfahren die Möglichkeit zur "Filterung" von Nanodrähten bzgl. Länge und Durchmesser (Breite) während des Kontaktdrucks beinhaltet. Um Nanodrähte einer bestimmten vordefinierten Breite oder Länge bevorzugt lokal deponieren zu können, können Strukturen vertikal oder lateral zur Bewegungsrichtung als Fänger eingesetzt werden, wobei der Abstand der gegenüberliegenden Strukturen die bevorzugt zu deponierende Breite oder Länge bestimmt (siehe Figur 7a).

Auch Stufen unterschiedlicher Höhe, Variationen in der Dichte von Nanopartikeln, die Geometrie der Fängerstrukturen u.s.w. können zu einer Filterung der Länge und der Breite eingesetzt werden. Eine weitere Möglichkeit ist die Beeinflussung der Verteilung der deponierten Nanodrähte durch die Geometrie der Fängerstrukturform (z.B. ein erhöhtes Dreieck; siehe Figur 7b)).

Neben der linearen Deposition können Nanodrähte auch prinzipiell in anderen Formen abgelegt werden. Dies ist einerseits möglich durch eine effektive Kopplung der tribologischen Wechselwirkung mit einer Variation der Abstreifrichtung (z.B. x-y- statt nur x-Komponente im Geschwindigkeitsvektor), aber auch durch geometrische bzw. tribologische "Führungsschienen" auf der Oberfläche d.h. gezielt auf der Substratoberfläche platzierte positive und negative Fängerstrukturen (siehe Fig. 7c)). Auch in Fig 4c) ist für den oberen Nanodraht bereits zu erkennen, dass sich dieser an den Gold-Nanopartikel orientiert nicht linear abgeschieden wurde.

### Beispiel 7 - Diamant als Subtrat

Wird in eine nanokristalline Diamantschicht (NCD) eine Vertiefung von 1 µm mittels Sauerstoffplasma geätzt, dann erfolgt keine Abscheidung der Nanodrähte auf der Erhöhung (wie bei Si₃N₄), sondern auf den tiefer liegenden Bereichen (d.h. dem Boden der Vertiefung). Durch den Ätzprozess kann z.B. die tribologische Wechselwirkung der geätzten Oberflächen signifikant erhöht sein (z.B. Rauigkeit), was wieder zur lokalen Deposition ausgenutzt werden kann (siehe Fig. 8).

## Patentansprüche

1. Verfahren zur Herstellung eines mit Nanodrähten strukturierten Substrats, umfassend die Schritte:
a) Bereitstellung eines Substrates, das an einer Oberfläche mindestens einen ersten Bereich mit ersten tribologischen Eigenschaften und mindestens einen zweiten Bereich mit zweiten tribologischen Eigenschaften enthält, wobei die ersten und zweiten tribologischen Eigenschaften verschieden sind und der erste Bereich den zweiten Bereich zumindest bereichsweise kontaktiert, wobei der zweite Bereich einen zum ersten Bereich unterschiedlichen Reibungskoeffizienten aufweist;
b) Anpressen eines Donorsubstrats enthaltend Nanodrähte mit einem bestimmten Anpressdruck auf den ersten Bereich des Substrats, sodass die Nanodrähte zumindest bereichsweise den ersten Bereich des Substrats kontaktieren; und
c) Bewegen des Donorsubstrats relativ zu dem Substrat in Richtung von dem ersten Bereich über mindestens den zweiten Bereich mit einer bestimmten Geschwindigkeit;
**dadurch gekennzeichnet, dass** in dem Verfahren kein Gleitmittel verwendet wird und nur durch das Bewegen des Donorsubstrats in Schritt c) und die unterschiedlichen tribologischen Eigenschaften der beiden Bereiche selektiv an lokal definierten Stellen des ersten und/oder zweiten Bereichs eine bestimmte Anzahl Nanodrähte abgelegt wird.

2. Verfahren gemäß Anspruch 1, **dadurch gekennzeichnet, dass** die unterschiedlichen tribologischen Eigenschaften über mindestens eine Fängerstruktur erreicht werden, die der erste und/oder zweite Bereich enthält oder daraus besteht, oder die optional darauf aufgebracht wird.

3. Verfahren gemäß Anspruch 2, **dadurch gekennzeichnet, dass** die mindestens eine Fängerstruktur
a) im ersten Bereich ein Material enthält oder daraus besteht, das zu einem Material des zweiten Bereichs identisch oder verschieden ist;
b) im zweiten Bereich ein Material enthält oder daraus besteht, das zu einem Material des ersten Bereichs identisch oder verschieden ist;
c) im ersten Bereich eine topographische Struktur aufweist oder daraus besteht, die zu der topographischen Struktur des zweiten Bereichs identisch oder verschieden ist; und/oder
d) im zweiten Bereich eine topographische Struktur aufweist oder daraus besteht, die zu der topographischen Struktur des ersten Bereichs identisch oder verschieden ist.

4. Verfahren gemäß einem der Ansprüche 2 oder 3, **dadurch gekennzeichnet, dass** die mindestens eine Fängerstruktur ein Metall, eine Metallverbindung, ein Halbmetall, eine Halbmetallverbindung, einen Kunststoff und/oder Kohlenstoff, insbesondere Gold, Pt, Al, Si, Ge, SiO₂, Si₃N₄, Diamant, Al₂O₃ und/oder TiN, enthält oder daraus besteht.

5. Verfahren gemäß einem der Ansprüche 3 oder 4, **dadurch gekennzeichnet, dass** die topographische Struktur ausgewählt ist aus der Gruppe bestehend aus flächigen, linearen und/oder punktuellen topographischen Strukturen, wobei die topographische Struktur bevorzugt eckig, rund oder gekrümmt ist und insbesondere eine Dreiecksform, eine Quaderform, eine Zylinderform, eine Kugelform, eine Halbkugelform, eine Erhöhung und/oder eine Vertiefung, enthält oder daraus besteht.

6. Verfahren gemäß einem der Ansprüche 2 bis 5, **dadurch gekennzeichnet, dass** die mindestens eine Fängerstruktur Nanopartikel enthält oder daraus besteht.

7. Verfahren gemäß einem der vorhergehenden Ansprüche, **dadurch gekennzeichnet, dass** auf den ersten und/oder zweiten Bereich mindestens zwei Fängerstrukturen aufgebracht werden, wobei jeweils zwei Fängerstrukturen einen Abstand zueinander aufweisen, der im Wesentlichen dem Durchmesser eines Nanodrahtes des Donorsubstrats entspricht.

8. Verfahren gemäß einem der vorhergehenden Ansprüche, **dadurch gekennzeichnet, dass** die Nanodrähte in einer von der Linearität abweichenden Geometrie auf dem Substrat abgelegt werden, bevorzugt in einer gekrümmten Geometrie.

9. Verfahren gemäß dem vorhergehenden Anspruch, **dadurch gekennzeichnet, dass** die Ablegung in einer von der Linearität abweichenden Geometrie erreicht wird durch
i) Bewegen des Donorsubstrats relativ zu dem Substrat in unterschiedlichen Richtungen relativ zum ersten Bereich und/oder zweiten Bereich einer bestimmten Geschwindigkeit; und/oder
ii) Bewegen des Donorsubstrats über mindestens eine Fängerstruktur, die der erste und/oder zweite Bereich enthält oder daraus besteht oder die optional auf diesem aufgebracht wird.

10. Verfahren gemäß einem der vorhergehenden Ansprüche, **dadurch gekennzeichnet, dass** im ersten Bereich und/oder zweiten Bereich oder zwischen beiden Bereichen mindestens ein Graben erstellt wird oder angeordnet ist, wobei der Graben bevorzugt zumindest bereichsweise von mindestens einem Nanodraht überspannt wird und/oder mindestens ein Nanodraht zumindest bereichsweise in dem Graben abgelegt wird, insbesondere die Länge des mindestens einen Grabens bevorzugt weniger als die halbe Länge der Nanodrähte beträgt.

11. Verfahren gemäß einem der vorhergehenden Ansprüche, **dadurch gekennzeichnet, dass** die Nanodrähte
i) ein Metall, Halbmetall und/oder Kohlenstoff enthalten oder daraus bestehen, bevorzugt Silizium, Germanium, ZnO und/oder Kohlenstoffnanoröhrchen; und/oder
ii) vor Schritt b) über einen Vakuum-Prozess, bevorzugt einen Goldkatalysierten "vapour-liquid-solid"-Prozess, oder über einen trockenen oder nasschemischen Ätzprozess hergestellt werden; und/oder
iii) eine Länge von 100 nm bis 1 mm, bevorzugt 1 µm bis 500 µm, besonders bevorzugt 5 µm bis 200 µm, insbesondere 10 µm bis 100 µm, aufweisen; und/oder
iv) einen Durchmesser von 1 nm bis 5 µm, bevorzugt 2 nm bis 500 nm, besonders bevorzugt 5 nm bis 200 nm, insbesondere 10 nm bis 100 nm, aufweisen; und/oder
v) zumindest bereichsweise eine konische, zylindrische, gekrümmte und/oder eckige Struktur aufweisen; und/oder
vi) zumindest bereichsweise oder vollständig metallisch leitend, p-leitend, n-leitend, intrinsisch leitend und/oder nichtleitend sind.

12. Substrat, enthaltend an einer Oberfläche
a) mindestens einen ersten Bereich mit ersten tribologischen Eigenschaften;
b) mindestens einen zweiten Bereich mit zweiten tribologischen Eigenschaften, wobei der zweite Bereich den ersten Bereich zumindest bereichsweise kontaktiert; und
c) mindestens einen Nanodraht, der den ersten und/oder zweiten Bereich zumindest bereichsweise kontaktiert;
wobei der erste und zweite Bereich unterschiedliche tribologische Eigenschaften aufweisen und der erste und/oder zweite Bereich selektiv an lokal definierten Stellen eine bestimmte Anzahl Nanodrähte enthält,
**dadurch gekennzeichnet, dass** das Substrat durch das Verfahren gemäß Anspruch 1 herstellbar ist.

13. Verwendung des Substrats gemäß Anspruch 12 in der Analytik, Materialsynthese, Mikroelektronik, Mikrosystemtechnik und/oder Mikrosensorik.

## Claims

1. Method for the production of a substrate structured with nanowires, comprising the steps:
a) Providing a substrate which, on one surface, comprises at least one first region with first tribological properties and at least one second region with second tribological properties, the first and second tribological properties being different and the first region contacting the second region at least in regions, wherein the friction coefficient of the second region is different to the first region;
b) Pressing a donor substrate comprising nanowires with a specific contact pressure on the first region of the substrate so that the nanowires contact the first region of the substrate at least in regions; and
c) Moving the donor substrate relative to the substrate in the direction from the first region over at least the second region at a specific speed;
**characterised in that**, in the method, no lubricant is used and, merely by moving the donor substrate in step c) and the different tribological properties of the two regions, a specific number of nanowires is deposited selectively at locally defined sites of the first and/or second region.

2. Method according to claim 1, **characterised in that** the different tribological properties are achieved via at least one collector structure which the first and/or second region comprises or consists of, or which is applied optionally thereon.

3. Method according to claim 2, **characterised in that** the at least one collector structure
a) in the first region, comprises a material or consists thereof, which is identical to or different from a material of the second region;
b) in the second region, comprises a material or consists thereof, which is identical to or different from a material of the first region;
c) in the first region, comprises a topographical structure or consists thereof, which is identical to or different from the topographical structure of the second region; and/or
d) in the second region, comprises a topographical structure or consists thereof, which is identical to or different from the topographical structure of the first region.

4. Method according to one of the claims 2 or 3, **characterised in that** the at least one collector structure comprises a metal, a metal compound, a semimetal, a semimetal compound, a plastic material and/or carbon, in particular gold, Pt, Al, Si, Ge, SiO₂, Si₃N₄, diamond, Al₂O₃ and/or TiN, or consists thereof.

5. Method according to one of the claims 3 or 4, **characterised in that** the topographical structure is selected from the group consisting of planar, linear and/or point-type topographical structures, wherein the topographical structure is preferably angular, round or curved and especially has a triangular shape, a cuboid shape, a cylindrical shape, a spherical shape, a semi-spherical shape, a raised portion and/or a depression or consists thereof.

6. Method according to one of the claims 2 to 6, **characterised in that** the at least one collector structure comprises nanoparticles or consists thereof.

7. Method according to one of the preceding claims, **characterised in that** on the first and/or second region, at least two collector structures are disposed, wherein respectively two collector structures having a spacing relative to each other which corresponds essentially to the diameter of a nanowire of the donor substrate.

8. Method according to one of the preceding claims, **characterised in that** the nanowires are deposited on the substrate in a geometry which deviates from linearity, preferably in a curved geometry.

9. Method according to the preceding claim, **characterised in that** deposition in a geometry which deviates from linearity is achieved by
i) moving the donor substrate relative to the substrate in different directions relative to the first region and/or second region at a specific speed; and/or
ii) moving the donor substrate over at least one collector structure which the first and/or second region comprises or consists of, or which is optionally applied on the latter.

10. Method according to one of the preceding claims, **characterised in that**, in the first region and/or second region or between both regions, at least one groove is produced or is disposed, the groove being preferably spanned by at least one nanowire at least in regions and/or at least one nanowire is deposited in the groove at least in regions, in particular the length of the at least one groove being preferably less than half the length of the nanowires.

11. Method according to one of the preceding claims, **characterised in that** the nanowires
i) comprise a metal, semimetal and/or carbon or consist thereof, preferably silicon, germanium, ZnO and/or carbon nanotubes; and/or
ii) are produced, before step b), via a vacuum process, preferably a gold-catalysed "vapour-liquid-solid" process, or via a dry- or wetchemical process; and/or
iii) have a length of 100 nm to 1 mm, preferably 1 µm to 500 µm, particularly preferably 5 µm to 200 µm, in particular 10 µm to 100 µm; and/or
iv) have a diameter of 1 nm to 5 µm, preferably 2 nm to 500 nm, particularly preferably 5 nm to 200 nm, in particular 10 nm to 100 nm; and/or
v) have a conical, cylindrical, curved and/or square structure at least in regions; and/or
vi) are metallically conducting, p-conducting, n-conducting, intrinsically conducting and/or non-conducting at least in regions or completely.

12. Substrate comprising, on one surface,
a) at least one first region with first tribological properties;
b) at least one second region with second tribological properties, the second region contacting the first region at least in regions;
c) at least one nanowire which contacts the first and/or second region at least in regions;
wherein the first and second region have different tribological properties and the first and/or second region comprises a specific number of nanowires selectively at locally defined sites,
**characterized in that** the substrate is producible by the method according to claim 1.

13. Use of the substrate according to claim 12 in analytics, material synthesis, microelectronics, microsystem technology and/or microsensor systems.

## Revendications

1. Procédé de fabrication d'un substrat structuré par des nanofils, comprenant les étapes :
a) fourniture d'un substrat qui sur une surface contient au moins un premier domaine ayant des premières propriétés tribologiques et au moins un deuxième domaine ayant des deuxièmes propriétés tribologiques, les premières et les deuxièmes propriétés tribologiques étant différentes, et le premier domaine étant au moins par zones en contact avec le deuxième domaine, le deuxième domaine présentant un coefficient de frottement différent de celui du premier domaine ;
b) pression d'un substrat donneur contenant des nanofils à l'aide d'une pression de contact définie sur le premier domaine du substrat, de telle sorte que les nanofils soient au moins par zones en contact avec le premier domaine du substrat ; et
c) déplacement, à une certaine vitesse, du substrat donneur par rapport au substrat dans la direction partant du premier domaine et passant par au moins le deuxième domaine ;
**caractérisé en ce qu'**aucun lubrifiant n'est utilisé dans le procédé, et **en ce que** ce n'est que par le déplacement du substrat donneur dans l'étape c) et grâce aux propriétés tribologiques différentes des deux domaines qu'un certain nombre de nanofils sont déposés sélectivement en des points localement définis du premier domaine et/ou du deuxième domaine.

2. Procédé selon la revendication 1, **caractérisé en ce que** les propriétés tribologiques différentes sont réalisées par l'intermédiaire d'au moins une structure de capture, qui contient le premier et/ou le deuxième domaines ou en est constituée, ou qui en option est appliquée par-dessus.

3. Procédé selon la revendication 2, **caractérisé en ce que** l'au moins une structure de capture
a) contient dans le premier domaine un matériau, ou en est constituée, qui est identique à un premier matériau du deuxième domaine, ou en est différent ;
b) contient dans le deuxième domaine un matériau, ou en est constituée, qui est identique à un matériau du premier domaine ou en est différente ;
c) présente dans le premier domaine une structure topographique, ou en est constituée, qui est identique à la structure topographique du deuxième domaine, ou en est différente ; et/ou
d) dans le deuxième domaine, présente une structure topographique, ou en est constituée, qui est identique à la structure topographique du premier domaine, ou en est différente.

4. Procédé selon l'une des revendications 2 ou 3, **caractérisé en ce que** l'au moins une structure de capture contient, ou en est constituée, un métal, un composé métallique, un métalloïde, un composé métalloïdique, un plastique et/ou un carbone, en particulier l'or, Pt, Al, Si, Ge, SiO₂, Si₃N₄, du diamant, Al₂O₃ et/ou TiN.

5. Procédé selon l'une des revendications 3 ou 4, **caractérisé en ce que** la structure topographique est choisie dans le groupe consistant en les structures topographiques bidimensionnelles, linéaires et/ou ponctuelles, la structure topographique étant de préférence polygonale, circulaire ou curviligne, et contient, ou en est constituée, une forme triangulaire, une forme parallèlépipèdique, une forme cylindrique, une forme sphérique, une forme en demi-sphère, une protubérance et/ou un renfoncement.

6. Procédé selon l'une des revendications 2 à 5, **caractérisé en ce que** l'au moins une structure de capture contient des nanoparticules, ou en est constituée.

7. Procédé selon l'une des revendications précédentes, **caractérisé en ce qu'**on applique sur le premier domaine et/ou sur le deuxième domaine au moins deux structures de capture, chaque groupe de deux structures de capture présentant une distance de l'une à l'autre, qui pour l'essentiel correspond au diamètre d'un nanofil du substrat donneur.

8. Procédé selon l'une des revendications précédentes, **caractérisé en ce que** les nanofils sont déposés sur le substrat selon une géométrie qui s'écarte de la linéarité, de préférence sous forme d'une géométrie curviligne.

9. Procédé selon la revendication précédente, **caractérisé en ce que** le dépôt est réalisé selon une géométrie différente de la linéarité, par
i) déplacement du substrat donneur par rapport au substrat dans des directions différentes par rapport au premier domaine et/ou au deuxième domaine, à une certaine vitesse ; et/ou
ii) déplacement du substrat donneur par l'intermédiaire d'au moins une structure de capture qui contient le premier et/ou le deuxième domaines et/ou en est constituée, ou qui en option est appliquée sur ces derniers.

10. Procédé selon l'une des revendications précédentes, **caractérisé en ce que** dans le premier domaine et/ou dans le deuxième domaine ou entre les deux domaines, une tranchée est créée ou disposée, la tranchée étant de préférence au moins par zones recouverte par au moins un nanofil, et/ou au moins un nanofil étant au moins par zones déposé dans la tranchée, en particulier la longueur de l'au moins une tranchée étant de préférence inférieure à la demi-longueur des nanofils.

11. Procédé selon l'une des revendications précédentes, **caractérisé en ce que** les nanofils
i) contiennent, ou en sont constitués, un métal, un métalloïde et/ou un carbone, de préférence le silicium, le germanium, ZnO et/ou les nanotubes de carbone ; et/ou
ii) avant l'étape b), sont fabriqués par un procédé sous vide, de préférence un procédé "vapour-liquid-solid" (vapeur-liquide-solide) catalysé par de l'or, ou par un procédé de gravure à sec ou chimique par voie humide ; et/ou
iii) présentent une longueur de 100 nm à 1 mm, de préférence de 1 µm à 500 µm, d'une manière particulièrement préférée de 5 µm à 200 µm, en particulier de 10 µm à 100 µm ; et/ou
iv) présentent un diamètre de 1 nm à 5 µm, de préférence de 2 nm à 500 nm, d'une manière particulièrement préférée de 5 nm à 200 nm, en particulier de 10 nm à 100 nm ; et/ou
v) présentent au moins par zones une structure conique, cylindrique, curviligne et/ou polygonale ; et/ou
vi) au moins par zones ou complètement, présentent une conduction métallique, une conduction p, une conduction n, une conduction intrinsèque et/ou une absence de conduction.

12. Substrat contenant sur une surface
a) au moins un premier domaine ayant des premières propriétés tribologiques ;
b) au moins un deuxième domaine ayant des deuxièmes propriétés tribologiques, le premier domaine étant au moins par zones en contact avec le premier domaine ; et
c) au moins un nanofil, qui au moins par zones est en contact avec le premier domaine et/ou le deuxième domaine ;
dans lequel le premier et le deuxième domaines présentent des propriétés tribologiques différentes, et le premier et/ou le deuxième domaines contiennent sélectivement en des points localement définis un certain nombre de nanofils,
**caractérisé en ce que** le substrat peut être fabriqué par le procédé selon la revendication 1.

13. Utilisation du substrat selon la revendication 12 en analytique, synthèse des matériaux, microélectronique, technique des microsystèmes et technologie des microcapteurs.
